# EUROPEAN PATENT SPECIFICATION

(11) **EP 3 184 501 B1**
(45) Date of publication and mention of the grant of the patent: **25.03.2020**
(21) Application number: 16205666.7
(22) Date of filing: 21.12.2016
(51) Int. Cl.: C04B 37/02, C04B 41/45, C04B 41/50, C04B 41/51

(54) **METHOD FOR MANUFACTURING A METAL-CERAMIC SUBSTRATE AND USE OF AN ELECTRICALLY INSULATING THICK-FILM PASTE**
VERFAHREN ZUR HERSTELLUNG EINES METALL-KERAMIK-SUBSTRATS UND VERWENDUNG EINER ELEKTRISCH ISOLIERENDEN DICKSCHICHTPASTE
PROCÉDÉ DE FABRICATION D'UN SUBSTRAT EN MÉTAL-CÉRAMIQUE ET UTILISATION D'UNE PÂTE EN COUCHE ÉPAISSE ELECTRIQUEMENT ISOLANTE

(30) Priority: 22.12.2015 EP 15201819
(43) Date of publication of application: 28.06.2017
(73) Proprietor: Heraeus Deutschland GmbH & Co. KG, 63450 Hanau (DE)
(72) Inventor: Gundel, Paul, 60594 Frankfurt (DE); Miric, Anton, 63755 Alzenau (DE); Modes, Christina, 60439 Frankfurt am Main (DE); Zier, Gabriel, 92670 Windischeschenbach (DE); Bawohl, Melanie, 63454 Hanau (DE); Herbst, Kai, 61118 Bad Vilbel (DE)
(74) Representative: Gille Hrabal

(56) References cited:
- GB-A- 2 418 538
- US-A- 4 910 492
- US-A- 6 020 048
- US-A1- 2004 163 555
- US-A1- 2005 051 253
- US-B1- 6 444 920
- M. G. NORTON: "Glass-ceramic interactions and thick-film metallization of aluminium nitride", JOURNAL OF MATERIALS SCIENCE, vol. 26, no. 9, 1 January 1991 (1991-01-01), pages 2322-2328, XP055275515, Dordrecht ISSN: 0022-2461, DOI: 10.1007/BF01130176
- OGAWA T ET AL: "EFFECT OF INORGANIC BINDERS ON THE PROPERTIES OF THICK FILM COPPER CONDUCTOR", IEEE TRANSACTIONS ON COMPONENTS, PACKAGING ANDMANUFACTURING TECHNOLOGY: PART A, IEEE SERVICE CENTER, PISCATAWAY, NJ, US, vol. 17, no. 4, 1 December 1994 (1994-12-01), pages 625-630, XP000484693, ISSN: 1070-9886, DOI: 10.1109/95.335049

## Description

The present invention relates to a method for manufacturing a metal-ceramic substrate having improved thermal stability, as well as the use of thick-film paste to provide metal-ceramic substrates with improved thermal stability.

For applications of power electronics, for instance in the automotive industry for hybrid and electric vehicles, it is necessary that the applied circuits have a capability for carrying high current and high durability under thermal and electrical cycle. Such a structure, which requires a conductive material with a capacity for carrying very high current material, is for example copper as the metal coated on the ceramic substrate which has in addition a good heat dissipation. In addition, it is necessary that a good binding ability of the copper surface via a bonding wire, a good solderability and the possibility of an oxidation protection through electroless electroplating layer are provided. These requirements can be fulfilled for example by the use of metal-ceramic substrates on the basis of the direct bonded copper (DCB) technology.

Appropriate single or double-sided metallized ceramic substrates are known generally. Such metal-ceramic substrates are used in particular in the area of power semi-conductor modules as a circuit carrier. These circuit carriers have on the top and bottom side of the substrate a copper metallization, wherein at least one metallized side exhibits a circuitry structure. The method for manufacturing this metal-ceramic composite by eutectic bonding is commonly referred to as direct-bonding process (direct copper bonding DCB) and known to the person skilled in the art. Respective descriptions of the methods for producing metallized ceramic substrates by the bonding method can be found in the patent documents US 3,744,120, US 3,994,430, EP 0085914 A or DE 23 19 854 A, the corresponding disclosure of which is incorporated by reference in the present invention.

In addition to the DCB substrates other ceramic substrates are known as well, which are metallized by an aluminum layer. For manufacturing these metal-ceramic substrates, significantly lower processing temperatures are required in comparison to the DCB method.

The lifetime of the metallized substrates is, however, restricted by the different thermal-expansion coefficient of the substrate and metallization. Mechanical tensions occur in operation due to temperature variations and different material expansions. These different material expansions lead in particular to a delamination process between the substrate and the metallization. Other disadvantages include a relatively high waste and the formation of so-called gas inclusions.

In order to reduce the tension, it is known for example from patent DE 43 18 241 A1 that structures can be introduced in the edge area of the metal layer, through which the occurrence of cracks is delayed.

According to patent DE 10 2012 024 063 A1, a method for producing a metallized ceramic substrate is known, in which the copper layer is applied not directly onto the ceramic substrate, but an aluminum-magnesium layer or aluminum-silicon layer is arranged between the copper layer and the ceramic substrate. This additional layer of aluminum and magnesium or aluminum and silicon is able to reduce the binding temperature to a range of 600 to 700 °C, which is otherwise usually between 1000 and 1100 °C in the DCB method, whereby the stability of resulting metal ceramic substrate is improved.

US 2005/0051253 A discloses a ceramic substrate which is coated directly with several metallic conductive coatings. Between these metallic coatings the ceramic paste is printed thereby filling the gaps between the metallic conductive coatings. The ceramic paste is not used in this document to enhance the terminal mechanical stability of the system.

US 2004/0163555 A discloses the ceramic substrate which is provided with a metallic conductive coating, whereby ceramic paste is filled in the gaps between the metallic conductive coating. The respective ceramic paste is obtained mixing a ceramic powder of, for example, a dielectric ceramic, magnetic ceramic, glass, glass ceramic, or other suitable ceramic powders with an organic vehicle. There is no further information provided about a specific constitution of the ceramic paste.

GB 2 418 538 A, US 6 444 920 B1 and US 6 020 048 A disclose metal-ceramic substrates.

However, the known method for manufacturing metal-ceramic substrates, in which thermal or mechanical tensions are reduced, is not satisfactory yet in terms of their feasibility and mode of action. Moreover, there exists still the problem of delamination of the substrate and the metallization during operation

Therefore, the present invention has the object to provide a metal-ceramic substrate having improved thermal stability. The present invention has the further object to reduce the risk of delamination between the substrate and the metallization during operation. These objects should be solved in particular for metal-ceramic-systems of the DCB-, DAB- or AMB-technology (DCB = direct copper bonding; DAB = direct aluminum bonding; AMB = active metal brazing). Moreover, the technology described herein is also directed to metal-ceramic-substrates in which a thick-film paste is provided between the ceramic substrate and the metal foil. Such metal-ceramic substrates are described in the prior, but non-published European patent application EP 15 201 817.2 with the title "Thick-film paste mediated ceramics bonded with metal or metal hybrid foils".

### The method for manufacturing a metal-ceramic substrate according to the invention

The metal-ceramic substrate is characterized in that the metallic coating is applied directly onto the ceramic substrate and is surrounded by a baked thick-film layer.

According to the invention, it was found out that the thermal stability of the metal-ceramic substrate can be improved by the use of a baked thick-film layer, which is arranged in a special manner around the metallic coating of the ceramic substrate. By doing so, the risk of delamination during operation between the metallization and the ceramic substrate can be reduced.

The provided thick-film layer, which improves the thermal stability of the metal-ceramic substrate and reduces the risk of delamination during operation, is generally prepared starting from a thick-film paste, which is baked on the metal-ceramic substrate.

In the following, the composition of the used thick-film paste according to the present invention is described in detail at first. Composition of the thick-film paste

### Electrically conductive thick-film paste (not according to the invention)

The thick-film layer is obtained from an electrically conductive thick-film paste. The resulting thick-film layer on the metal-ceramic substrate is thereby also designed to be electrically conductive.

The used thick-film paste comprises preferably at least one metal, at least one organic vehicle and at least one adhesion promotor and/or glass material.

The first component of this thick-film paste, the metal, may be included in the thick-film paste in an amount of usually 50 to 90 wt%, preferably 60 to 90 wt%, more preferably 70 to 90 wt%, more preferably 80 to 90 wt%, related to total weight of the thick-film paste.

The thick-film paste comprises preferably at least one metal component, which may be selected from the group consisting of metals of the Group 11 element (copper, silver and gold), aluminum, nickel and mixtures thereof.

The metals used in the thick-film paste may have any particle size and any particle form, with any bulk density, and conductivity.

Furthermore, the thick-film paste may comprise optionally an adhesion promoter, which can be selected for example from the group consisting of copper oxide, titanium oxide, zirconia, boron resin, zirconium resin, amorphous boron, lithium phosphate, bismuth oxide, aluminum oxide and zinc oxide. The amount of the adhesion promoter included in the thick-film paste can be 0.1 to 8 wt%, more preferably 1 to 6 wt%, much more preferably 2 to 5 wt%, in relation to the total amount of the thick-film paste.

A further optional component of the thick-film paste is a glass material, preferably in an amount of 0.1 to 8 wt%, preferably 1 to 6 wt%, more preferably 2 to 5 wt%, in relation to the total amount of the thick-film paste.

A further component of the thick-film paste includes at least an organic vehicle, preferably in an amount of 5 to 20 wt%, more preferably 5 to 15 wt%, in relation to the total amount of the thick-film paste.

The glass material and the organic vehicle are described below.

The thick-film paste composition comprises copper as a metal component, a metal oxide as an adhesion promoter, a glass material and an organic vehicle. All components of the thick-film paste described above and below may be used as powder.

The thick-film paste comprises copper as a metal component, a Bi₂O₃ as an adhesion promoter, a glass material and an organic vehicle.

The thick-film paste composition comprises copper as a metal component in an amount of 80 to 90 wt%, Bi₂O₃ as adhesion promoter in an amount of 1 to 5 wt%, a glass material in an amount of 1 to 5 wt%, an organic vehicle in an amount of 5 to 15 wt%, each in relation to the total amount of the thick-film paste.

### Electrically insulating thick-film paste (according to the invention)

In an embodiment according to the invention, the thick-film layer is obtained from an electrically insulating thick-film paste. The resulting thick-film layer on the metal-ceramic substrate is therefore also designed to be electrically insulating.

Due to the use of an electrically insulating thick-film paste, it is possible to dispose adjacent metallic coatings to each other more closely without having the risk of causing a short circuit between the metal layers.

The electrically insulating thick-film paste preferably comprises at least one metal oxide and/or at least one glass material, optionally at least one pigment, such as cobalt aluminate, and at least one organic vehicle.

The pigment serves as color marking component which renders the final thick-film paste into a material that can be visually detected and each pigment which can provide this functionality to the thick-film paste is suitable in the sense of the present invention.

The metal oxides used in the electrically insulating thick-film paste may be selected from the group consisting of Al₂O₃, CuO, Cu₂O, MnO, Mn₂O₃, MnO₂, ZnO, TeO₂, PbO, Pb₃O₄, PbO₂, MgO, CaO, Y₂O₃, and Bi₂O₃.

The electrically insulating thick-film paste may comprise the metal oxide in an amount of preferably 0 to 92 wt%, more preferably 0 to 80 wt%, much more preferably 0.1 to 70 wt%, each in relation to the total amount of the thick-film paste.

If the electrically insulating thick-film paste is used, the thick-film paste may comprise the glass material in an amount of preferably 0 to 92 wt%, more preferably 0 to 80 wt%, much more preferably 0.1 to 70 wt%, much more preferably 10 to 70 wt%, much more preferably 20 to 70 wt%, much more preferably 30 to 70 wt%, each in relation to the total amount of the thick-film paste.

If the electrically insulating thick-film paste is used, the thick-film paste may comprise the pigment in an amount of preferably 2 to 15 wt%, more preferably 2 to 10 wt%, much more preferably 3 to 7 wt%, each in relation to the total amount of the thick-film paste.

If the electrically insulating thick-film paste is used, the thick-film paste may comprise the organic vehicle in an amount of preferably 8 to 90 wt%, more preferably 20 to 80 wt%, much more preferably 30 to 70 wt%, each in relation to the total amount of the thick-film paste.

The electrically insulating thick-film paste has a solid content in an amount of 30 to 70 wt%, each in relation to the total amount of the thick-film paste.

The defined solid content is a compromise according to the present invention. If the solid content is too high, a dense cauterization (burning) of the thick-film paste is possible. However, the thick-film paste deteriorates due to a large amount of solid content in respect to the applicability, and therefore, a solid content having an amount of 30 to 70 wt% in relation to the amount of the thick-film paste is particularly preferably from these points of view.

### Organic vehicle

The thick-film pastes may comprise preferably an organic vehicle which evaporates or decomposes by baking of the thick-filmpaste.

The organic vehicle is preferably provided as a solution, emulsion or dispersion on the basis of one or more solvents, which guarantees that the aforementioned components of the thick-film paste are present in a dissolved, emulsified or dispersed form. A solvent is preferably used. Preferable organic vehicles are those systems which guarantee the stability of the components of the thick-film paste and provide such a viscosity of the thick-film paste, that the thick-film paste can be easily applied.

Preferred organic vehicle comprises
(1) a binder, preferably in an amount of 1 to 10 wt%, more preferably in an amount of 2 to 8 wt%, much more preferably in an amount of 3 to 7 wt%, each in relation to the amount of the organic vehicle;
(2) a surfactant, preferably in an amount of 0 to 10 wt%, more preferably in an amount of 0% to 8 wt%, even more preferably in an amount of 0.01 to 6 wt%, each in relation to the amount of the organic vehicle;
(3) additives, preferably in an amount of 0 to 5 wt%, more preferably in an amount of 0 to 13 wt%, much more preferably in an amount of 5 to 11 wt%, each in relation to the amount of the organic vehicle;
(4) at least one solvent, which is added in an amount that the total amount of mentioned ingredients (i) to (iv) is added up to 100 wt% as the amount of the organic vehicle.

The binder of the organic vehicles is preferably selected that the resulting thick-film paste has a sufficient stability, applicability and viscosity. Suitable binders are known to the person skilled in the art per se and may be selected for example from the group consisting of polymeric binders, monomeric binders and binder systems, which include both polymeric binders and monomeric binder.

Polymeric binders can also include copolymers, in which at least two different monomer units are linked to a polymer. Preferable polymeric binders are those which carry a functional group in the main chain, a functional group in the side chain or a functional group in the main chain and the side chain. Preferable polymeric binders, which carry the functional group in the main chain, are for example optionally substituted polyesters; optionally substituted polycarbonates; polymers carrying a cyclic group in the main chain; optionally substituted polysaccharides; optionally substituted polyurethanes; optionally substituted polyamides; optionally substituted phenol resins; copolymers of the monomers of one of the aforementioned polymers (optionally with other co-monomers); or a combination of at least two of them. Preferable polymers, which carry a cyclic group in the main chain, are for example, polyvinyl butylate (PVB) and derivatives thereof, poly terpineol and derivatives thereof or mixtures thereof. Preferable polysaccharides are for example, cellulose, and alkyl derivatives thereof, preferably methyl cellulose, ethyl cellulose, propyl cellulose, butyl cellulose, derivatives thereof and mixtures of at least two of the aforementioned polysaccharides. Preferable polymers, which carry the functional group in the side chain, are for example those which has amide groups or acid and/or ester groups (usually referred to as acryl resin), or polymers comprising a combination of the aforementioned functional groups and mixtures thereof. Preferable polymers, which carry amide groups in the side chain, are for example polyvinylpyrrolidone (PVP) and derivatives thereof. Preferable polymers, which carry acid and/or ester groups in the side chain, are for example, polyacrylic acid and derivatives thereof, polymethacrylates (PMA) and derivatives thereof, and poly (methyl methacrylate) (PMMA) and derivatives thereof, or mixtures of the aforementioned polymers. Preferable monomeric binders are based on ethylene glycol monomers, terpineol resin or derivatives of cellulose or mixtures thereof. Preferable monomeric binding agent based on ethylene glycol are those having an ether or ester function, or an ester and ether function, wherein preferable ether functions are methyl, ethyl, propyl, butyl, pentyl, hexyl and a higher alkyl ether functional groups and preferable ester functions are acetate or alkyl derivatives thereof, more preferably is ethylene glycol monobutyl ether monoacetat. Alkyl cellulose is preferably ethyl cellulose, derivatives thereof and mixtures thereof with other binders of the aforementioned binding agents are much more preferred.

The surfactant used in the organic vehicles is preferably selected that the resulting thick-film paste has sufficient stability, applicability and viscosity. Suitable surfactants are known to the person skilled in the art per se and may be selected for example from the group consisting of surfactants, which exhibit a linear, branched, aromatic, fluorinated siloxane-containing or polyether-containing chain or a combination of the aforementioned chains. Preferable surfactants are formed as single-chain, dichain or poly-chain. Preferable surfactants have nonionic, anionic, cationic or zwitterionic functions. Preferable surfactants are further polymeric or monomeric surfactants or mixtures thereof. Preferable surfactants have pigment-affine groups, more preferably having hydroxyl-functional carboxyl ester function with pigment-affine groups (e.g., DISPERBYK®-08, manufactured by BYK USA, Inc.), acrylate copolymers with pigment-affine groups (e.g., DISPERBYK®-116, manufactured by BYK USA, Inc.), modified polyether with pigment affinity groups (e.g., TEGO® DISPERS 655, manufactured by Evonik Tego Chemie GmbH). Further preferable surfactants are polyethylene glycol and derivatives thereof, alkyl carboxylic acids and derivatives or salts thereof or mixtures thereof. The preferable polyethylene glycol derivative is poly (ethylene glycol) acetic acid. Preferable alkyl carboxylic acids are fully saturated or those having a simple-unsaturated or polyunsaturated groups, and mixtures thereof. Preferable carboxylic acid having saturated alkyl chains are those having a length of alkyl chain of 8 to 20 carbon atoms, preferably C₉H₁₉COOH (capric acid), C₁₁H₂₃COH (lauric acid), C₁₃H₂₇COOH (myristic acid), C₁₅H₃₁COOH (palmitic acid), C₁₇H₃₅COOH (stearic acid) and mixtures thereof. Preferable carboxylic acids having unsaturated alkyl chain are C₁₈H₃₄O₂ (oleic acid) and C₁₈H₃₂O₂ (linoleic acid). The preferable monomeric surfactants are benzotriazole and derivatives thereof.

The solvent of the organic vehicles is preferably selected that the resulting thick-film paste has sufficient stability, applicability, and viscosity. Suitable solvents are known to the person skilled in the art per se and are those solvents which can be removed from the thick-film paste through baking substantially. Particularly, the solvent, which can be removed through baking, have an amount of at least 80 wt%, more preferably at least 95 wt % in relation of solvent content before baking. The solvents may be selected for example from the group consisting of solvents, which have a boiling point above 90 °C under standard conditions (25 °C, 100 kPa) and a melting point of below 20 °C. Preferable solvents are non-polar, protic or aprotic, aromatic or non-aromatic solvent. More preferable solvents are monoalcohols, dialcohols, polyalcohol, monoesters, diesters, polyesters, monoethers, diethers, polyethers; solvents, which have more than one of the aforementioned functionalities, and optionally contain additional functional groups, such as cyclic groups, aromatic groups, unsaturated bonds, alcoholic groups, in which one or more oxygen atoms are substituted with heteroatoms; and mixtures of two or more of the aforementioned solvents. In the composition, preferable esters are dialkyl esters of adipic acid with alkyl groups selected from the group consisting of methyl, ethyl, propyl, butyl, pentyl, hexyl, and longer alkyl-chain groups, or combinations of two different alkyl groups, preferably dimethyl adipate, and mixtures of two or more adipate esters , preferable ethers in the composition are diethers, preferably dialkyl ethers of ethylene glycol, wherein preferable alkyl moieties includes methyl, ethyl, propyl, butyl, pentyl, hexyl, and higher alkyl groups, or combinations of two different of the abovementioned alkyl groups as well as mixtures of two diethers. Preferable alcohols in the composition are primary, secondary or tertiary alcohols, terpineol and derivatives thereof, or mixtures of two or more alcohols. Preferable solvents which comprise more than one different functional group, are 2,2,4-trimethyl-1,3-pentanediol, mono-isobutyrate (also referred to as texanol) and derivatives thereof, 2-(2-ethoxyethoxy) ethanol (carbitol as hereinafter) and alkyl derivatives thereof, in particular methyl, ethyl, propyl, butyl, pentyl and hexyl carbitol, more preferably hexyl carbitol, and acetate derivatives thereof, much more preferably butyl carbitol acetate, or mixtures of at least two of the aforementioned solvents.

The additives of the organic vehicles are chosen preferably that the resulting thick-film paste has a sufficient stability, applicability and viscosity; and the additives are further different from the above-mentioned ingredients. These additives are known to the person skilled in the art per se. Preferable additives include thixotropy additive, viscosity regulators, stabilizing agents, inorganic additives, thickening agents, emulsifying agents, dispersing agents, and pH agents. Preferable thixotropy additive are carboxylic acid derivatives, preferably derivatives of fatty acid or combinations thereof. Preferable derivatives of fatty acid are C₉H₁₉COOH (capric acid), C₁₁H₂₃COOH (lauric acid), C₁₃H₂₇COOH (myristic acid), C₁₅H₃₁COOH (palmitic acid), C₁₇H₃₅COOH (stearic acid) C₁₈H₃₄O₂ (oleic acid) C₁₈H₃₂O₂ (linoleic acid) or combinations thereof. A preferred fatty acid in the composition is castor oil.

### Glass material

The thick-film pastes may comprise preferably a glass material. Appropriate components as the glass material can be selected from the group consisting of PbO, Bi₂O₃, TeO₂, ZnO, B₂O₃, SiO₂, Al₂O₃, TiO₂, ZrO₂, K₂O, Na₂O, MgO, Fe₂O₃, CaO, Cr₂O₃ and Li₂O.

With regard to Bi₂O₃, this compound can be used either as an adhesive promotor or in the glass material.

The glass material comprises for example,
PbO in an amount of 0 to 90 wt%, more preferably in an amount of 0.1 to 80 wt%, much more preferably in an amount of 0.1 to 70 wt% in relation to the amount of the glass material;;
TeO₂ in an amount of 0 to 90 wt%, more preferably in an amount of 0.1 to 80 wt%, much more preferably in an amount of 0.1 to 70 wt% in relation to the amount of the glass material;
Bi₂O₃ in an amount of 0 to 90 wt%, more preferably in an amount of 0.1 to 80 wt%, much more preferably in an amount of 0.1 to 70 wt% in relation to the amount of the glass material;
ZnO in an amount of 0 to 5 wt%, more preferably in an amount of 0.01 to 2 wt%, much more preferably in an amount of 0.1 to 1 wt% in relation to the amount of the glass material;
B₂O₃ in an amount of 0 to 30 wt.%, more preferably in an amount of 1 to 20 wt%, much more in an amount of 1 to 15 wt% in relation to the amount of the glass material;
SiO₂ in an amount of 0 to 90 wt%, more preferably in an amount of 10 to 80 wt%, much more preferably in an amount of 20 to 70 wt% in relation to the amount of the glass material;
Al₂O₃ in an amount of 0 to 10 wt%, more preferably in an amount of 0.01 to 8 wt%, much-more preferably in an amount of 0.1 to 5 wt% in relation to the amount of the glass material;
TiO₂ in an amount of 0 to 20 wt%, more preferably in an amount of 0.1 to 15 wt%, much more preferably in an amount of 1 to 10 wt% in relation to the amount of the glass material;
ZrO₂ in an amount of 0 to 5 wt%, more preferably in an amount of 0.01 to 2 wt%, much more preferably in an amount of 0.03 to 1 wt% in relation to the amount of the glass material;
K₂O in an amount of 0 to 20 wt%, more preferably in an amount of 0.1 to 15 wt%, much more preferably in an amount of 1 to 10 wt% in relation to the amount of the glass material;
Na₂O in an amount of 0 to 10 wt%, more preferably in an amount of 0.1 to 7 wt%, much more preferably in an amount of 0.1 to 5 wt% in relation to the amount of the glass material;
MgO in an amount of 0 to 5 wt%, more preferably in an amount of 0.01 to 2 wt%, much more preferably in an amount of 0.1 to 1 wt% in relation to the amount of the glass material;
Fe₂O₃ in an amount of 0 to 5 wt%, more preferably in an amount of 0 to 2 wt%, much more preferably in an amount of 0 to 1 wt% in relation to the amount of the glass material;
CaO in an amount of 0 to 30 wt%, more preferably in an amount of 1 to 20 wt%, much more preferably in an amount of 1 to 15 wt% in relation to the amount of the glass material;
Cr₂O₃ in an amount of 0 to 5 wt%, more preferably in an amount of 0.01 to 2 wt%, much more preferably in an amount of 0.01 to 1 wt% in relation to the amount of the glass material;
Li₂O in an amount of 0 to 5 wt%, more preferably in an amount of 0.01 to 2 wt%, even more preferably in an amount of 0.1 to 1 wt% in relation to the amount of the glass material.

### Metal-ceramic substrate

The metal-ceramic substrate may be a substrate of DCB (direct copper bond), DAB (direct aluminum bond) or AMB (active metal brazing). Moreover, the technology described herein is also directed to metal-ceramic-substrates in which a thick-film paste is provided between the ceramic substrate and the metal foil.

The substrate used in the metal-ceramic substrate can be-selected in particular to be from the group consisting of Al₂O₃, ZTA, AIN, Si₃N₄, and BeO.

The electrically conductive thick-film layer provided on the metal-ceramic substrate has a porosity of preferably at least 5%, more preferably at least 7%, much more preferably at least 10%. The porosity of the thick-film layer and the presence of glass materials and/or metal oxides makes it possible to distinguish the thick-film layer from the metal coating applied on the ceramic substrate since the metal coating applied on the ceramic substrate has usually a porosity of less than 3%, in particular of less than 2%, further in particular of less than 1%. The thick-film layer may be disposed onto the metal coating of the ceramic substrate in a close manner (such as form-fitting).

In the process, not according to the present invention, it is possible that the thick-film layer is disposed only around a portion of the metal coating on the ceramic substrate in a close manner (such as form-fitting). Alternatively, not according to the invention, the thick-film layer may be disposed around the entire metal coating of ceramic substrate in a close manner (such as form-fitting).

It is also possible that the thick-film layer is disposed around the metallic coating and overlaps the metallic coating on the substrate.

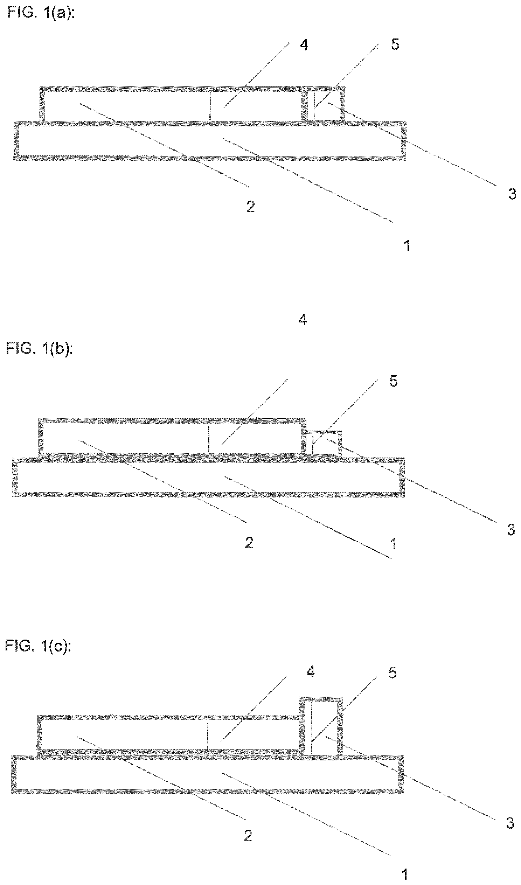

If the thick-film layer is disposed around the metallic coating, the thick-film layer may substantially have the same layer thickness as the metallic coating. Alternatively, it is also possible that the layer has a substantially smaller or larger layer thickness than the metallic coating. These three embodiments are represented in Figures 1(a) to 1(c). The reference numbers in these figures mean:
1. ceramic substrate
2. metallic coating
3. thick-film layer, which is disposed onto the metallic coating in a manner of form-fitting manner,
4. layer thickness of the metallic coating 2
5. layer thickness of the thick-film layer 3

In Figure 1(a), the thick-layer film 3 has a layer thickness 5 being substantially identical to the layer thickness 4 of the metallic coating 2 while in Figure 1(b) the layer thickness 5 of the thick-film layer 3 is substantially smaller than the layer thickness of the metallic coating 2; and in Figure 1(c), the layer thickness 5 of the thick-film layer 3 is substantially larger than the layer thickness of the metallic coating 2.

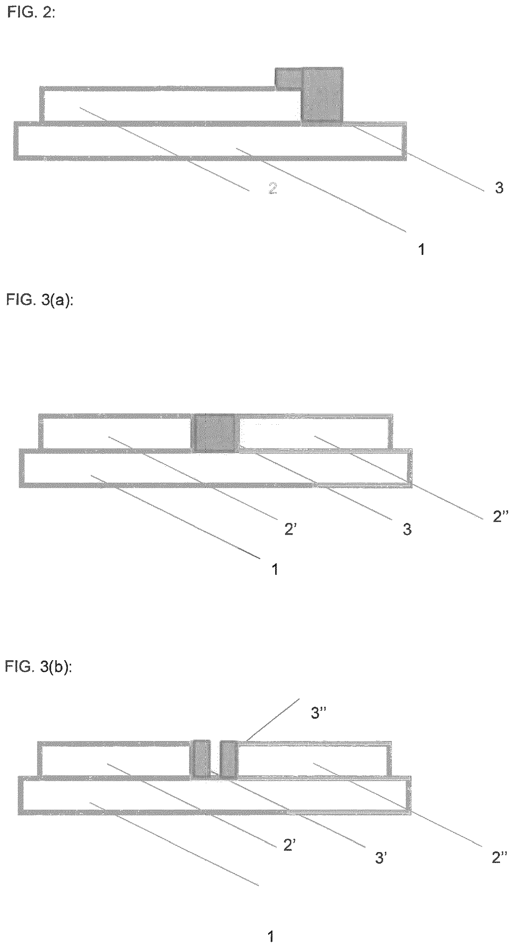

The preferable embodiment of the present invention is represented in Figure 2, in which the baked thick-film paste 3 covers the edge side of the metal coating 2.

The thick-film layer extends laterally to the metallic coating with a width perpendicular of the metallic coating of at least 30 µm, more preferably at least 40 µm, much more preferably at least 50 µm.

In a further preferred embodiment of the present invention, the metal-ceramic substrate has a plurality of metallic coatings, which are separated from each other. In this embodiment, the thick-film paste and the resulting backed thick-film layer covers the entire area between two adjacent metallic coatings (filling the gap between the metallization). This embodiment is represented in Figure 3(a), wherein 2 'and 2" are each adjacent metallic coating arranged on a ceramic substrate 1.

In a further preferred embodiment of the present invention, the thick-film layer is not provided to the entire area between two adjacent metallic coatings, which results in two isolated thick-film layers 3' and 3", each of them are arranged around the metallic coatings 2' and 2". This embodiment is represented in Figure 3(b). Thereby, the width of the thick-film layers 3' and 3" perpendicular to the metallic coatings 2' and 2" are preferably at least 30 µm, more preferably at least 40 µm, much more preferably at least 50 µm.

### Methods according to the present invention

Furthermore, the present invention relates to a method for the preparation of the metal-ceramic substrate according to the present invention.

The method according to the present invention is characterized by the following steps:
a. providing a DBC (Direct Copper Bonding), DAB (Direct Aluminum Bonding) or AMB (Active Metal Brazing) substrate comprising a ceramic substrate and a metal coating applied thereon or a metal-ceramic-substrate in which a thick-film paste is provided between the ceramic substrate and the metal foil;
b. applying an electrically insulating thick-film paste around the metal coating of the ceramic substrate, whereby the thick-film paste has a solid content in an amount of 30 to 70 wt% in relation to the total amount of the thick-film paste;
c. optionally drying the thick-film paste; and
d. baking the thick-film paste.

In step a., the starting material of the metal-ceramic substrate according to the present invention is provided. The preparation of such metal-ceramic substrates, for example, by means of the DCB method is known to the person skilled in the art.

In step b., the thick-film paste is applied onto the substrate preferably by means of an inkjet method, a dispensing method, a screen printing method, a stencil printing method (template printing method), a pad method, a dipping method or by means of a spatula method.

In optional step c., the thick-film paste is dried at a temperature of preferably 50 to 300 °C, more preferably from 60 to 250 °C, much more preferably from 100 to 150 °C.

In step d., the baking of the thick-film paste takes place preferably under an inert atmosphere, for example in the presence of argon or nitrogen, or under a reducing atmosphere, for example in the presence of hydrogen.

In process step d., the baking of the thick-film paste is carried out at a temperature of preferably 500 to 1090 °C, more preferably from 700 to 1080 °C, much more preferably from 800 to 1070 °C.

The method according to the invention is particularly suitable for producing an above-described metal-ceramic substrate. Therefore, the already mentioned implementation for the thick-film paste is especially applicable for the method according to the present invention. In detail:
The thick-film paste used can be designed to be electrically conductive (not according to the invention) or electrically insulating (according to the invention).

The thick-layer film is obtained from an electrically conductive thick-film paste, which is not according to the invention. The resulting thick-film layer on the metal-ceramic substrate is therefore also designed to be electrically conductive.

The thick-film paste to be used not according to the invention comprises preferably at least one metal, at least one organic vehicle and at least one adhesion promoter and/or glass material.

The first component of the thick-film paste, the metal, may be included in the thick-film paste in an amount of usually 50 to 90 wt%, preferably 60 to 90 wt%, more preferably 70 to 85%, related to the amount of the thick-film paste.

The thick-film paste not according to the invention comprises preferably at least one metal component, which may be selected from the group consisting of metals of the Group 11 element (copper, silver and gold), aluminum, and nickel.

The metals used in the thick-film paste may have any particle size and any particle form, with any bulk density, and conductivity.

Furthermore, the thick-film paste may comprise optionally an adhesion promoter, which can be selected for example from the group consisting of copper oxide, titanium oxide, zirconia, boron resin, zirconium resin, amorphous boron, lithium phosphate, bismuth oxide, aluminum oxide and zinc oxide. The amount of the adhesion promoter included in the thick-film paste can be 0.1 to 8 wt%, more preferably 1 to 6 wt%, much more preferably 2 to 5 wt% in relation to the amount of the thick-film paste.

A further optional component of the thick-film paste is glass material, preferably in an amount of 0.1 to 8 wt%, more preferably 0.1 to 6 wt%, more preferably 2 to 5 wt%, in relation to the amount of the thick-film paste.

A further component of the thick-film paste may include at least an organic vehicle, preferably in an amount of 5 to 20 wt.%, more preferably 5 to 15 wt.%, in relation to the amount of the thick-film paste.

The glass material and the organic vehicle were already described above.

The thick-film paste composition not according to the invention comprises copper as a metal component, a metal oxide as adhesion promoter, a glass material and an organic vehicle. All components of the thick-film paste described above and below may be used as powder.

The thick-film paste not according to the invention comprises copper as a metal component, Bi₂O₃ as an adhesion promoter, a glass material and an organic vehicle.

The thick-film paste composition not according to the invention comprises copper as a metal component in an amount of 80 to 90 wt%, Bi₂O₃ as adhesion promoter in an amount of 1 to 5 wt%, a glass material in an amount of 1 to 5 wt%, and an organic vehicle in an amount of 5 to 15 wt%, each in relation to the total amount of the thick-film paste.

In an embodiment according to the invention, the thick-film layer is obtained from an electrically insulating thick-film paste. The resulting thick-film layer on the metal-ceramic substrate is therefore also designed to be electrically insulating.

The electrically insulating thick-film paste preferably may comprise at least one metal oxide, at least one glass material, at least one pigment, such as cobalt aluminate, and at least one organic vehicle.

The pigment serves as colour marking component which renders the final thick-film paste into a material that can be visually detected and each pigment which can provide this functionality to the thick-film paste is suitable.

If an electrically insulating thick-film paste is used, the metal oxides used therein may be selected from the group consisting of Al₂O₃, CuO, Cu₂O, MnO, Mn₂O₃, MnO₂, ZnO, TeO₂, PbO, Pb₃O₄, PbO₂, MgO, CaO, Y₂O₃ and Bi₂O₃.

If an electrically insulating thick-film paste is used, the thick-film paste may comprise the metal oxide in an amount of preferably 0 to 92 wt%, more preferably 0 to 80 wt%, much more preferably 0.1 to 70 wt%, each in relation to the amount of the thick-film paste.

If an electrically insulating thick-film paste is used, the thick-film paste may comprise the glass material in an amount of preferably 0 to 92 wt%, more preferably 0 to 80 wt%, much more preferably 0.1 to 70 wt%, much more preferably 10 to 70 wt%, much more preferably 20 to 70 wt%, much more preferably 30 to 70 wt%, each in relation to the amount of the thick-film paste.

If an electrically insulating thick-film paste is used, the thick-film paste may comprise optionally the pigment in an amount of preferably 2 to 15 wt%, more preferably 2 to 10 wt%, much more preferably 3 to 7 wt%, each in relation to the amount of the thick-film paste.

If an electrically insulating thick-film paste is used, the thick-film paste may comprise the organic vehicle in an amount of preferably 3 to 90 wt%, more preferably 8 to 80 wt%, much more preferably 30 to 70 wt%, each in relation to the amount of the thick-film paste.

The electrically insulating thick-film paste has a solid content in an amount of 30 to 70 wt%, each in relation to the total amount of the thick-film paste.

The metal-ceramic substrate is a DCB (direct copper bond), DAB (direct aluminum bond) or AMB (active metal brazing) substrate.

The substrate used in the metal-ceramic substrate can be selected from the group consisting of Al₂O₃, ZTA, AIN, Si₃N₄, and BeO.

The electrically conductive thick-film layer not according to the invention provided on the metal-ceramic substrate has a porosity of preferably at least 5%, more preferably at least 7%, much more preferably at least 10%. The porosity of the thick-film layer and the presence of glass materials and/or metal oxides makes it possible to distinguish the thick-film layer from the metal coating applied on the ceramic substrate since the metal coating applied on the ceramic substrate has usually a porosity of less than 3%, in particular of less than 2%, further in particular of less than 1%.

The thick-film layer may be disposed around the metal coating of the ceramic substrate in a close manner (such as form-fitting).

In the process, not according to the present invention, it is possible that the thick-film layer is disposed only around a portion of the metal coating on the ceramic substrate in a close manner (such as form-fitting). Alternatively, not according to the invention, the thick-film layer is disposed around the entire metal coating of ceramic substrate in a close manner (such as form-fitting). It is also possible that the thick-film layer is disposed around the metallic coating and overlaps the metallic coating on the substrate.

The embodiments are shown in Figures 1(a) to 1(c) and 2.

### Use of thick-film pastes

In a further aspect, the present invention relates to the use of an electrically insulating thick-film paste thick-film paste as described in the appended claim 4 to improve the thermal stability of the metal-ceramic substrate.

Moreover, the present disclosure which is not claimed relates to the use of a thick-film paste for preparing a thick-film layer on a metal-ceramic substrate to reduce the risk of delamination between the metallization and the substrate (during operation under thermal cycles).

For this purpose, a thick-film paste as described above is arranged around the metallic coating of the metal-ceramic substrate on the metal-ceramic substrate at first, and then baked under the above-described method conditions.

The thick-film paste can be arranged only at a portion of the metallic coating, for example, on one edge, two edges or three edges of the metallic coating, or clasp completely around the metallic layer.

For further embodiments, reference is made to the above description.

### Examples:

The following thick-film pastes 1 and 2 can be applied onto a commercially available metal-ceramic substrate, which was prepared by means of the DCB method. The thickness of the copper foils is 300 or 600µm.

### Thick-film paste composition 1 (electrically insulating thick-film paste): according to the invention

50.00 wt% of glass powder in a composition with
0.36 wt% ZnO;
9.59 wt% B₂O₃;
60.83 wt% SiO₂;
3.18 wt% Al₂O₃;
6.42 wt% TiO₂;
0.05 wt% ZrO₂;
6.55 wt.% K₂O;
2.84 wt% Na₂O;
0.43 wt% MgO;
0.14 wt.% Fe₂O₃;
8.85 wt% CaO;
0.01 wt% Cr₂O₃; and
0.68 wt% Li₂O;

50 wt% of organic vehicles in a composition with
92.50 wt% texanol; and
7.50 wt% ethyl cellulose.

### Thick-film paste composition 2 (electrically conductive thick-film paste): not according to the invention

85.00 wt% of a copper powder;
3.00 wt% Bi₂O₃ powder;
3.00 wt% of a glass powder in a composition with
   0.36 wt% ZnO;
   9.59 wt% B₂O₃;
   60.83 wt% SiO₂;
   3.18 wt% Al₂O₃;
   6.42 wt% TiO₂;
   0.05 wt% ZrO₂;
   6.55 wt% K₂O;
   2.84 wt% Na₂O;
   0.43 wt% MgO;
   0.14 wt% Fe₂O₃;
   8.85 wt.% CaO;
   0.01 wt% Cr₂O₃; and
   0.68 wt% Li₂O;
9 wt% of an organic vehicle in a composition with
   43.00 wt% texanol;
   23.00 wt% butyl diglyme; and
   34.00 wt% iso-butyl methacrylate.

The metal-ceramic substrates having a baked thick-film layer on the basis of thick-film pastes 1 and 2, which are produced by starting with thick-film pastes 1 and 2, are subjected to thermal cycle (15 minutes at -40 °C; 15 seconds transfer time; 15 minutes at 150 °C). The obtained results are shown in the following table:

| thickness of copper foil/thickness of the paste-amplifying | Appearance of delamination after the thermal cycle, according to the invention (same substrate, same metallization; with the thick-film paste composition 1 or 2; same results are achieved) | Appearance of delamination after the thermal cycle, comparison (same substrate; same metallization; without any of the thick-film paste composition 1 or 2) |
|---|---|---|
| 300 µm / 50 µm (maximum height, however thereafter leveling) | delamination after more than 2000 cycles | delamination after less than 100 cycles |
| 600 µm / 50 µm (maximum height, however thereafter leveling) | delamination after more than 300 cycles | delamination after less than 50 cycles |
| 300 µm / 100 µm (maximum height, however thereafter leveling) | delamination after more than 1300 cycles | delamination after less than 100 cycles |
| 600 µm / 100 µm (maximum height, however thereafter leveling) | delamination after more than 200 cycles | delamination after less than 50 cycles |

## Claims

1. A method for manufacturing a metal-ceramic substrate, **characterized by** the following steps:
a. supplying a DCB (Direct Copper Bonding, DAB (Direct Aluminum Bonding) or AMB (Active Metal Brazing) substrate comprising a ceramic substrate and a metallic coating thereon;
b. applying an electrically insulating thick-film paste around the metallic coating onto the ceramic substrate, whereby the thick-film paste has a solid content in an amount of 30 to 70 wt% in relation to the total amount of the thick-film paste;
c. optionally drying the thick-film paste; and
d. baking the thick-film paste.

2. A method according to claim 1, **characterized in that** in method step b. the thick-film paste is applied onto the substrate by an inkjet method, a dispensing method, a screen printing method, a stencil printing method, a pad method, a dipping method or by means of a spatula method.

3. Method according to claim 1 or 2, **characterized in that** the thick-film layer is obtained from starting with an electrically insulating thick-film paste.

4. Use of an electrically insulating thick-film paste having a solid content in an amount of 30 to 70 wt% in relation to the amount of the thick-film paste to improve the thermal stability of a metal-ceramic substrate comprising
a. a ceramic substrate, wherein at least one side of the ceramic substrate
b. is provided with a metallic coating,
wherein the metallic coating is applied directly onto the ceramic substrate and is surrounded at least partially by the thick-film layer being baked.

## Patentansprüche

1. Verfahren zur Herstellung eines Metall-Keramik-Substrats, **gekennzeichnet durch** die folgenden Schritte:
a. Bereitstellung eines DCB (Direct Copper Bonding), DAB (Direct Aluminium Bonding) oder AMB (Active Metal Brazing)-Substrats mit einem Keramiksubstrat und einer Metallbeschichtung darauf;
b. Aufbringen einer elektrisch isolierenden Dickschichtpaste um die Metallbeschichtung herum auf das Keramiksubstrat, wobei die Dickschichtpaste einen Feststoffgehalt von 30 bis 70 Gew.-% in Bezug zum Gesamtgehalt der Dickschichtpaste aufweist;
c. wahlweise Trocknen der Dickschichtpaste; und
d. Brennen der Dickschichtpaste.

2. Verfahren gemäß Anspruch 1, **dadurch gekennzeichnet, dass** in Verfahrensschritt b. die Dickschichtpaste auf das Substrat durch ein Tintenstrahlverfahren, ein Dosierungsverfahren ein Siebdruckverfahren, ein Schablonendruckverfahre, ein Pad-Verfahren, ein Tauchverfahren oder mittels eines Spachtelverfahrens aufgebracht wird.

3. Verfahren gemäß Anspruch 1 oder 2, **dadurch gekennzeichnet, dass** der Dickschichtfilm ausgehend von einer elektrisch isolierenden Dickschichtpaste erhalten wird.

4. Verwendung einer elektrisch isolierenden Dickschichtpaste mit einem Feststoffgehalt von 30 bis 70 Gew.-% in Bezug zum Gesamtgehalt der Dickschichtpaste zur Verbesserung der Wärmebeständigkeit eines Metall-Keramik-Substrats mit
a. einem Keramik-Substrat, wobei zumindest eine Seite des Keramik-Substrats
b. mit einer Metallbeschichtung versehen ist,
wobei die Metallbeschichtung direkt auf das Keramik-Substrat aufgebracht und zumindest teilweise von dem zu brennenden Dickschichtfilm umgeben wird.

## Revendications

1. Procédé de fabrication d'un substrat métal-céramique, **caractérisé par** les étapes suivantes de:
a. fournir un substrat DCB Direct Copper Bonding), DAB (Direct Aluminium Bonding ou AMB (Active Metal Brazing) comprenant un substrat en céramique et un revêtement métallique sur celui-ci ;
b. appliquer une pâte à couche épaisse isolant électriquement autour du revêtement métallique sur le substrat en céramique, la pâte à couche épaisse ayant une teneur en solide comprise entre 30 et 70 % en poids par rapport à la quantité totale de la pâte à couche épaisse :
c. facultativement sécher la pâte à couche épaisse ; et
d. cuire la pâte à couche épaisse.

2. Procédé selon la revendication 1, **caractérisé en ce que** dans l'étape de procédé b. la pâte à couche épaisse est appliquée sur le substrat à l'aide d'un procédé de jet d'encre, d'un procédé de distribution, d'un procédé de sérigraphie, d'un procédé d'impression à pochoir, d'un procédé à coussinet, d'un procédé d'immersion ou à l'aide d'un procédé de spatule.

3. Procédé selon la revendication 1 ou la revendication 2, **caractérisé en ce que** la couche en pellicule épaisse est obtenue à partir d'une pâte à couche épaisse isolant électriquement.

4. Utilisation d'une pâte à couche épaisse isolant électriquement ayant une teneur en solide comprise entre 30 et 70 % en poids par rapport à la quantité totale de la pâte à couche épaisse pour améliorer la stabilité thermique d'un substrat métal-céramique, comprenant
a. un substrat en céramique, dans lequel au moins une face du substrat en céramique
b. est munie d'un revêtement métallique,
dans lequel le revêtement métallique est directement appliqué sur le substrat en céramique et il est entouré au moins partiellement par la couche en pellicule épaisse à cuire.
